Europäisches Patentamt

European Patent Office

Office européen des brevets

(11) Veröffentlichungsnummer: **0 329 808**
**A1**

# (12) EUROPÄISCHE PATENTANMELDUNG

(21) Anmeldenummer: 88102801.3

(22) Anmeldetag: 25.02.88

(51) Int. Cl.⁴: **H05K 3/26 , H05K 3/34 , B23K 1/08**

(43) Veröffentlichungstag der Anmeldung:
30.08.89 Patentblatt 89/35

(84) Benannte Vertragsstaaten:
**AT BE CH DE ES FR GB IT LI NL SE**

(71) Anmelder: **Gebr. Schmid GmbH & Co.**
**Robert-Bosch-Strasse 34**
**D-7290 Freudenstadt(DE)**

(72) Erfinder: **Schmid, Dieter, C., Dipl.-Ing.**
**Am Schäferstich 19**
**D-7290 Freudenstadt(DE)**

(74) Vertreter: **Hoeger, Stellrecht & Partner**
**Uhlandstrasse 14 c**
**D-7000 Stuttgart 1(DE)**

(54) **Verfahren und Vorrichtung zur Reinigung frisch verzinnter Leiterplatten.**

(57) Um bei einem Verfahren zur Reinigung frisch verzinnter Leiterplatten (3), von überschüssigem Lot, bei dem man mindestens ein Fluid gegen ihre Oberfläche richtet, die Effektivität der Lotabreinigung zu verbessern, wird vorgeschlagen, daß man auf der dem Strahl gegenüberliegenden Seite der Leiterplatte Fluid absaugt. Weiterhin wird eine Vorrichtung zur Durchführung dieses Verfahrens Vorgeschlagen.

EP 0 329 808 A1

## Verfahren und Vorrichtung zur Reinigung frisch verzinnter Leiterplatten

Die Erfindung betrifft ein Verfahren zur Reinigung frisch verzinnter Leiterplatten von überschüssigem Lot, bei dem man mindestens einen Fluidstrahl gegen ihre Oberfläche richtet. Weiterhin betrifft die Erfindung eine Vorrichtung zur Durchführung dieses Verfahrens mit mindestens einer Düse, durch welche ein Fluidstrahl austritt, mit einer Halterung für eine Leiterplatte, die die Leiterplatte mit einer Oberfläche in den Strahl hält.

Elektrische Leiterplatten werden im Bereich der Leiterbahnen und der die Anschlüsse der elektrischen Bauelemente aufnehmenden Leiterplattenbohrungen verzinnt. Zu diesem Zweck werden sie in ein flüssiges Lotbad eingetaucht, so daß das flüssige Lot bestimmte entsprechend vorbehandelte Bereiche der Leiterplatte benetzt, andere aber nicht. Nach dem Eintauchen der Leiterplatte in das flüssige Lot haftet überschüssiges Lot an der Leiterplatte, insbesondere im Bereich der Bohrungen, die häufig von dem Lot vollständig erfüllt sind. Zur Entfernung überschüssigen Lotes ist es bekannt, einen Gasstrahl gegen die Leiterplatte zu richten, der auch die Leiterplattenbohrungen freilegt, dabei aber das an den verzinnten Bereichen haftende Lot nicht vollständig entfernt.

Es ist auch bekannt, diese als "Levelling" bekannte Reinigung von überschüssigem Lot innerhalb einer Flüssigkeit durchzuführen, beispeilsweise innerhalb eines wasserlöslichen Öles, welches sich auf einer Temperatur oberhalb der Schmelztemperatur des Lotes befindet. Statt eines Gasstrahles wird dann ein Flüssigkeitsstrahl gegen die Leiterplatte gerichtet, vorzugsweise ein Flüssigkeitsstrahl derselben Flüssigkeit, in die die Leiterplatte insgesamt eintaucht. Dieser Flüssigkeitsstrahl entfernt überschüssiges Lot von der Leiterplatte, welches sich in der die Leiterplatte umgebenden Flüssigkeit absetzt und von der Flüssigkeit abgetrennt werden kann. Diese Technik ist als "Oil Levelling" bekannt (Firmenprospekt Gebr. Schmid GmbH & Co. SCL-System).

Es ist Aufgabe der Erfindung, dieses bekannte Verfahren zur Entfernung überschüssigen Lotes von einer frisch verzinnten Leiterplatte weiter zu verbessern, insbesondere im Hinblick auf die Effektivität der Lotabtragung, die Schonung der aufgetragenen Lotschicht und den Energieverbrauch.

Diese Aufgabe wird bei einem Verfahren der eingangs beschriebenen Art erfindungsgemäß dadurch gelöst, daß man auf der dem Strahl gegenüberliegenden Seite der der Leiterplatte Fluid absaugt.

Es hat sich überraschenderweise herausgestellt, daß durch eine zusätzliche Absaugung auf der dem Strahl abgewandten Seite der Leiterplatte die Strömungsverhältnisse des durch den Strahl gegen die Leiterplatte gerichteten Fluids so günstig beeinflußt werden, daß bei gleicher Strahlintensität eine wirksamere Entfernung des überschüssigen Lotes von der Leiterplatte und insbesondere eine besonders effektive Freilegung der Bohrungen erreicht werden kann, da der Strom des Fluids durch die Bohrungen der Leiterplatte gegenüber bekannten Verfahren begünstigt wird, bei denen das Fluid auf der dem Strahl abgewandten Seite der Leiterplatte ein ruhendes Fluidkissen bildete, welches die Durchströmung der Bohrungen der Leiterplatte in gewissem Umfange behindert hat.

Unter "Fluid" kann sowohl ein Gas als auch vorzugsweise eine Flüssigkeit verstanden werden. Besonders geeignet für dieses Verfahren sind wasserlösliche Öle, jedoch läßt sich dass Verfahren auch mit beliebigen anderen Behandlungsflüssigkeiten für die Leiterplatte oder mit Gasen durchführen. Bei der Verwendung von Flüssigkeit ist es vorteilhaft, wenn sich die Leiterplatten innerhalb der Flüssigkeit befinden, wenn also auch der gegen die Leiterplatte gerichtete Strahl innerhalb eines Flüssigkeitsvolumens erzeugt wird. Auf diese Weise wird die Leiterplatte durch die umgebende Flüssigkeit gegenüber der Atmosphäre abgeschirmt.

Als besonders vorteilhaft hat es sich ergeben, wenn man das Fluid unmittelbar gegenüber der Auftreffstelle des Strahls auf die Leiterplatte absaugt. Es ergibt sich dann in dem Bereich zwischen der Auftreffstelle auf der einen Seite der Leiterplatte und der Absaugung auf der unmittelbar gegenüberliegenden Stelle der Leiterplatte ein wirksamer, durch die Platte hindurchgerichteter Fluidstrom, der zu einer besonders gründlichen Abtragung überschüssigen Lotes führt und trotzdem sehr wenig Energie benötigt, da die Strömung nur in einem sehr engen Bereich entsteht und da umliegende Bereiche des Fluids wesentlich weniger Bewegungsenergie aufnehmen als bei bekannten Verfahren ohne Absaugung.

Es ist auch Aufgabe der Erfindung, eine Vorrichtung zur Durchführung des genannten Verfahrens zu schaffen. Diese Aufgabe wird erfindungsgemäß durch eine Vorrichtung der eingangs beschriebenen Art gelöst, die gekannzeichnet ist durch eine auf der dem Strahl abgewandten Seite der Leiterplatte angeordnete Absaugung für das Fluid.

Vorzugsweise ist die Absaugung genau gegenüber einer Düse angeordnet.

Bei einem bevorzugten Ausführungsbeispiel kann vorgesehen sein, daß die Absaugung einen sich quer zur Leiterplatte erstreckenden Absaugschlitz aufweist und daß die Leiterplatte an diesem vorbeibewegt wird. "Quer" umfaßt dabei sowohl eine senkrechte Anordnung des Schlitzes relativ zur Vorschubrichtung als auch eine Anordnung unter einem von 90° abweichenden Winkel, z.B. unter 45°. Diese Anordnung wird üblicherweise mit einer ebenfalls schlitzförmigen Düse zur Erzeugung des auf der Leiterplatte auftreffenden Strahls kombiniert, so daß über die gesamte Breite der Leiterplatte einseitig ein vorhangähnlicher Strahl gegen die Leiterplatte gerichtet wird, während auf der gegenüberliegenden Seite in einer entsprechenden Konfiguration abgesaugt wird. Dadurch kann der Bereich der bewegten Flüssigkeit in Vorschubrichtung der Leiterplatte eng begrenzt werden.

Günstig ist es, wenn der Absaugschlitz eine Schlitzbreite zwischen 0,2 und 5 mm hat.

Eine besonders effektiv Absaugung ergibt sich, wenn der Abstand der Absaugung von der Leiterplatte zwischen 0,1 und 5 mm liegt. Da das Fluid an der Leiterplatte wie ein Schmierfilm anliegt, ist es möglich, die Absaugung bis unmittelbar an die Oberfläche der Leiterplatte heranreichen zu lassen ohne daß die Gefahr einer Beschädigung der verzinnten Leiterbahnen auf der Plattenoberfläche besteht, die Leiterbahnen werden durch den entstehenden Fluid ausreichend geschützt. Die Kombination von Strahldüse und Absaugung auf der gegenüberliegenden Seite der leiterplatte erzeugt einen sehr effektiven Fluidstrom durch die Bohrungen der Leiter platte hindurch, so daß eine bisher nicht erreichbare Freilegung der Bohrungen möglich wird.

Das beschriebene Verfahren und die dazugehörige Vorrichtung arbeiten sowohl bei senkrechter Anordnung der Leiterplatten, beispielsweise im Tauchverfahren, als auch bei horizontaler Anordnung, also beispielsweise bei einer Vorrichtung, in der die Leiterplatten kontinuierlich längs einer horizontalen Vorschubstrecke transportiert werden.

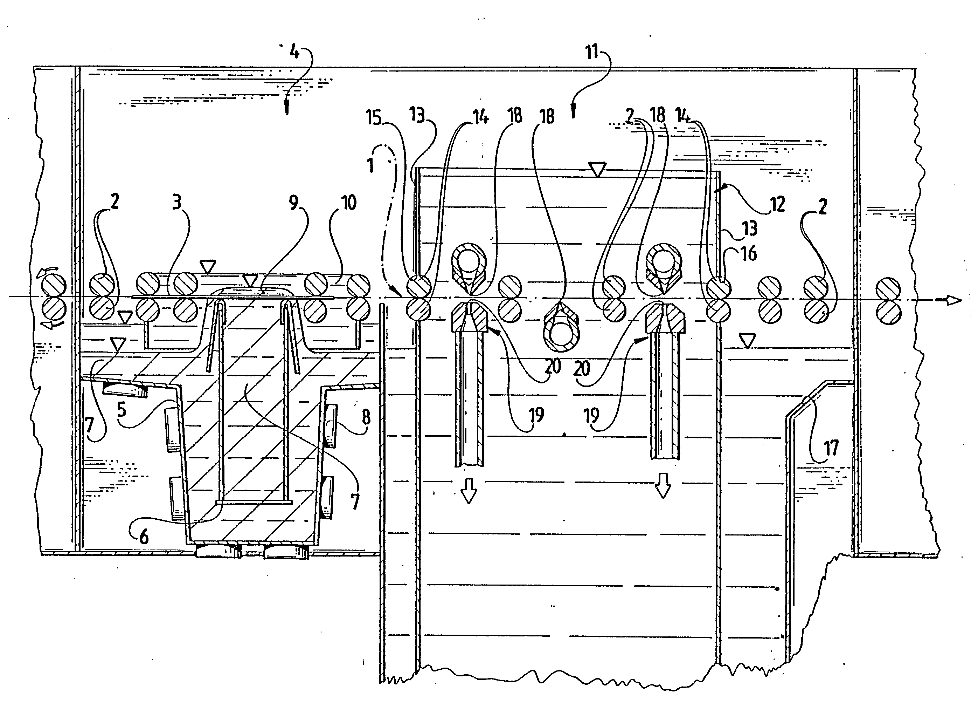

Die nachfolgende Beschreibung einer bevorzugten Ausführungsform der Erfindung dient im Zusammenhang mit der Zeichnung der näheren Erläuterung. Die Zeichnung zeigt dabei eine schematische Teillängsschnittansicht einer Vorrichtung zum Verzinnen und Entfernen überschüssigen Lots von Leiterplatten, die längs einer horizontalen Vorschubstrecke transportiert werden.

Diese horizontale Vorschubstrecke 1 wird durch eine Anzahl von unterhalb der Vorschubebene angeordneten, quer zur Vorschubrichtung sich erstreckenden Transportwalzen 2 gebildet, die auch in Form von einzelnen Transporträdern oder dergleichen ausgebildet sein können. Auch oberhalb der Vorschubebene sind derartige Transportwalzen 2 oder Transporträder vorgesehen, die so gelagert sein können, daß sie unter der Einwirkung ihres Gewichtes oder einer zusätzlichen Federkraft gegen entsprechende Transportwalzen unterhalb der Vorschubebene gedrückt werden, so daß die Walzen unmittelbar aneinander anliegen, wenn keine Leiterplatte zwischen ihnen fortbewegt wird, während beim Vorschieben einer Leiterplatte die Walten auf der Ober- und Unterseite der Leiterplatte 3 anliegen. Die Transportwalzen werden durch in der Zeichnung nicht dargestellte Mittel angetrieben und schieben die Leiterplatten 3 längs der Vorschubstrecke 1 durch die gesamte Vorrichtung.

Nach einer geeigneten Vorbehandlung gelangen die Leiterplatten zunächst in eine Verzinnungsstation 4. In dieser befindet sich unterhalb der Vorschubstrecke 1 ein Vorratsbehälter 5, in dem eine innerer Behälter 6 angeordnet ist. Der innere Behälter 6 ragt bis unmittelbar an die Vorschubebene heran und erstreckt sich über die gesamte Breite der Vorschubstrecke 1. Sowohl im Vorratsbehälter 5 als auch im inneren Behälter 6 befindet sich flüssiges Lot 7, das durch geeignete Heizelemente 8 auf einer Temperatur oberhalb des Schmelzpunktes gehalten wird. Durch in der Zeichnung nicht dargestellte Pumpen wird das Lot 7 aus dem inneren Behälter 6 nach oben gepumpt und bildet oberhalb des inneren Behälters 6 eine sogenannte Lotwelle 9, die sich über die Vorschubebene der Vorschubstrecke 1 erhebt, so daß längs der Vorschubstrecke 1 vorgeschobene Leiterplatten 3 durch diese Lotwelle 9 hindurchtransportiert werden, so daß die Leiterplatten beidseitig von dem flüssigen Lot benetzt werden.

Überschüssiges Lot fließt anschließend in den Vorratsbehälter 5 zurück und wird von diesem durch die Pumpen weider in den inneren Behälter 6 gepumpt. Der Füllstand im Vorratsbehälter 5 ist dabei so gewählt, daß der sich einstellende Lotspiegel unterhalb der Vorschubstrecke 1 liegt.

Das flüssige Lot kann in der Verzinnungsstation 4 mit einer Schicht aus einem Öl 10 bedeckt sein, so daß jeder unmittelbare Kontakt des Lotes 7 mit der darüber anstehenden Gasatmosphäre verhindert wird.

Nach dem Verlassen der Lotwelle 9 wird ein Teil des überschüssigen, an der Leiterplatte 3 haftenden Lotes durch die an der Oberseite und an der Unterseite der Leiterplatte vorbeilaufenden Transportwalzen entfernt. Trotzdem haftet an den Leiterplatten sowohl an den Leiterbahnen als auch insbesondere in den Bohrungen noch überschüssiges Lot, das in dr sich an die Verzinnungsstation 4 anschließenden Levelling-Station 11 von der Leiterplatte entfernt wird. Diese Levelling-Station 11 umfaßt einen Behälter 12, dessen Seitenwände 13 sich über die Höhe der Vorschubstrecke 1 erstrekken und im Bereich der Vorschubstrecke 1 durch paarige Walzen 14 verschlossene Einlauf-bzw. Auslaufschlitze 15 und 16 aufweisen. Der Behälter 12 ist bis über das Niveau der Vorschubstrecke 1 hinaus mit einer Flüssigkeit gefüllt, beispielsweise einem wasserlöslichen Öl, und befindet sich in einem Vorratsbehälter 17, der aus den Schlitzen 15 und 16 austretendes und über die Oberkante des Behälters 12 ausfließendes Öl auffängt. Das Öl wird mittels in der Zeichnung nicht dargestellter Pumpen aus dem Vorratsbehälter 17 in solcher Menge in den Behälter 12 eingepumpt, daß der Ölstand im Behälter 12 oberhalb der Vorschubstrecke 1 angeordnet ist. Außerdem Befinden sich im Vorratsbehälter 17 und gegebenenfalls auch im Behälter 12 Heizelemente, die das Öl auf eine Temperatur oberhalb der Schmelztemperatur des Lotes erwärmen.

Im Behälter 12 sind quer zur Vorschubrichtung der Leiterplatten unmittelbar oberhalb und unterhalb der Vorschubebene endende Düsen 18 angeordnet, die schlitzförmige, quer zur Vorschubrichtung über die gesamte Breite der Vorschubstrecke verlaufende Austrittsöffnungen aufweisen. Durch diese Düsen 18 wird mittels geeigneter, in der Zeichnung nicht dargestellter Pumpen ein Flüssigkeitsstrahl abgegeben und unmittelbar gegen die Oberfläche der längs der Vorschubstrecke 1 transportierten Leiterplatten 3 gerichtet. Die dabei verwendete Flüssigkeit ist in der Regel dieselbe Flüssigkeit, die zur Füllung der Behälter 12 und 17 verwendet wird, also beispielsweise ein wasserlösliches Öl.

In dem dargestellten Ausführungsbeispiel sind oberhalb der Vorschubebene zwei derartige Düsen 18 und zwischen diesen unterhalb der Vorschubebene eine weitere Düse 18 angeordnet, so daß zwei Flüssigkeitsstrahlen gegen die Oberseite und eine Flüssigkeitsstrahl gegen die Unterseite der Leiterplatte gerichtet werden. Die Düsen 18 enden dabei in geringem Abstand von der Leiterplatte, so daß eine Auffächerung der Strahlen vor dem Auftreffen auf die Leiterplatte verhindert wird.

Auf der der Vorschubebene gegenüberliegenden Seite ist den beiden oberhalb der Vorschubebene angeordneten Düsen 18 je eine Absaugung 19 zugeordnet. Jede Absaugung weist eine schlitzförmige Absauföffnung 20 auf, die sich parallel zu der schlitzförmigen Auslaßöffnung der Düsen 18 erstreckt und dieser unmittelbar gegenüberliegt. Der Abstand der Absaugöffnung 20 von der Unterseite der Leiterplatten wird in der Regel sehr gering gewählt, er kann beispielsweise zwischen 0,1 und 5 mm liegen, wobei ein unmittelbares Anliegen an der Unterseite der Leiterplatten möglich ist.

Obwohl in der Zeichnung der unterhalb der Vorschubebene angeordneten Düse 18 keine Absaugung auf der Oberseite der Vorschubstrecke 1 zugeordnet ist, kann eine solche Absaugung ebenfalls vorgesehen werden.

Durch die Absaugung entsteht eine sehr lokal beschränkte und im wesentlichen laminare Strömung der Flüssigkeit, die aus der Düse 18 austritt und durch die gegenüberliegende Absaugöffnung 20 wieder aufgenommen wird. Durch wird der umliegende Bereich der Flüssigkeit kaum beeinflußt, d.h. in diesem Bereich bleibt die Flüssigkeit im wesentlichen ruhig. Wenn eine Leiterplatte längs der Vorschubstrecke 1 vorgeschoben wird, tritt sie in diesen lokal begrenzten, sich quer über die gesamte Breite der Vorschubstrekke erstreckenden Strahl ein, wobei ein wesentlicher Teil der Flüssigkeit durch die Bohrungen der Leiterplatte unmittelbar zur Absaugung gelangt, d.h. man erhält auf diese Weise eine besonders effektive Entfernung überschüssigen Lotes, insbesondere im Bereich der Bohrlöcher.

Die Flüssigkeit nimmt dabei das entfernte Lot mit, welches sich am Boden des Behälters 12 absetzt und dort entnommen werden kann. Die Flüssigkeit selbst wird gegebenenfalls nach Durchlauf durch ein geeignetes Filter weider über die Düsen 18 zugeführt.

Die Absaugung muß nicht unmittelbar gegenüber einer Düse angeordnet sein, es wäre auch eine Versetzung in Richtung der Vorschubstrecke 1 möglich. Es hat sich jedoch gezeigt, daß eine besonders effektive Entfernung überschüssigen Lotes erreicht werden kann, wenn Düse und Absaugung einander unmittelbar gegenüberstehen.

## Ansprüche

1. Verfahren zur Reinigung frisch verzinnter Leiterplatten von überschüssigem Lot, bei dem man mindestens einen Fluidstrahl gegen ihre Oberfläche richtet,
dadurch gekennzeichnet,
daß man auf der dem Strahl gegenüberliegenden Seite der Leiterplatte Fluid absaugt.

2. Verfahren nach Anspruch 1,
dadurch gekennzeichnet,
daß man das Fluid unmittelbar gegenüber der Auftreffstelle des Strahls auf die Leiterplatte absaugt.

3. Vorrichtung zur Durchführung des Verfahrens der Ansprüche 1 oder 2 mit mindestens einer Düse, durch welche ein Fluidstrahl austritt, und mit einer Halterung für eine Leiterplatte, die die Leiterplatte mit einer Oberfläche in den Strahl hält,
gekennzeichnet durch
eine auf der dem Strahl abgewandten Seite der Leiterplatte (3) angeordnet Absaugung (19) für das Fluid.

4. Vorrichtung nach Anspruch 3,
dadurch gekennzeichnet,
daß die Absaugung (19) genau gegenüber einer Düse (18) angeordnet ist.

5. Vorrichtung nach Anspruch 3 und 4,
dadurch gekennzeichnet,
daß die Absaugung (19) einen sich quer zur Leiterplatte (3) erstreckenden Absaugschlitz (20) aufweist und daß die Leiterplatte (3) an diesem vorbeibewegt wird.

6. Vorrichtung nach Anspruch 5,
dadurch gekennzeichnet,
daß der Absaugschlitz (20) eine Schlitzbreite zwischen 0,2 und 5 mm hat.

7. Vorrichtung nach einem der Ansprüche 3 bis 6,
dadurch gekennzeichnet,
daß der Abstand der Absaugung (19) von der Leiterplatte (3) zwischen 0,1 und 5 mm liegt.

A 0610

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | GB-A-2 063 925 (GYREX CORP.) <br> * Seite 1, Zeile 126 - Seite 2, Zeile 8; Seite 2, Zeilen 65-71; Seite 3, Zeile 110 - Seite 3, Zeile 39; Figuren 1,6 * <br> --- | 1-4 | H 05 K 3/26 <br> H 05 K 3/34 <br> B 23 K 1/08 |
| A | EP-A-0 169 456 (IBM) <br> --- | | |
| A | US-A-3 868 272 (ELECTROVERT MANUFACTURING CO. LTD) <br> --- | | |
| A | DE-A-3 022 146 (GEBR. SCHMID GmbH) <br> * Seite 10, Absatz 2 - Seite 12, Absatz 3; Figur 1 * <br> ----- | 1-5 | |

|  |
|---|
| **RECHERCHIERTE SACHGEBIETE (Int. Cl.4)** |
| H 05 K <br> B 23 K <br> B 08 B |

Der vorliegende Recherchenbericht wurde für alle Patentansprüche erstellt

| Recherchenort | Abschlußdatum der Recherche | Prüfer |
|---|---|---|
| DEN HAAG | 27-10-1988 | SCHUERMANS N.F.G. |